Europäisches Patentamt

European Patent Office

Office européen des brevets

(19)

(11) Publication number: **0 409 127 A2**

# EUROPEAN PATENT APPLICATION

(12)

(21) Application number: **90113550.9**

(22) Date of filing: **16.07.90**

(51) Int. Cl.5: **H03L 7/185**

(30) Priority: **17.07.89 JP 185424/89**
**31.07.89 JP 196608/89**

(43) Date of publication of application:
**23.01.91 Bulletin 91/04**

(84) Designated Contracting States:
**DE FR GB IT NL SE**

(71) Applicant: **NEC CORPORATION**
**7-1, Shiba 5-chome Minato-ku**
**Tokyo 108-01(JP)**

(72) Inventor: **Watanabe, Nozomu**
**c/o NEC Corporation, 7-1 Shiba 5-chome**
**Minato-ku, Tokyo(JP)**

(74) Representative: **Vossius & Partnerner**
**Siebertstrasse 4 P.O. Box 86 07 67**
**D-8000 München 86(DE)**

(54) **Phase-locked loop type frequency synthesizer having improved loop response.**

(57) A frequency synthesizer using a phase-locked loop is disclosed. The frequency synthesis is accomplished by a closed loop arrangement comprising: a reference oscillator, a phase detector, a programmable counter, a phase detector, a loop filter, a voltage controlled oscillator (VCO), and a frequency translator. The phase detector is supplied with a reference signal from the reference oscillator and a signal from the programmable counter, and compares phases of the two signals. A frequency translator is provided in a manner to receive the signal from the VCO and downward translate the frequency of the signal received. The output of the frequency translator is fed to the programmable counter which divides a signal applied by a variable divide value and applies the divided signal to the phase detector.

FIG.2

EP 0 409 127 A2

# PHASE-LOCKED LOOP TYPE FREQUENCY SYNTHESIZER HAVING IMPROVED LOOP RESPONSE

The present invention relates to a frequency synthesizer using a phase-locked loop. More specifically, the present invention relates to such a phase-locked loop type frequency synthesizer which features a quick loop response even when frequency separation of the output signals is narrowed.

A frequency synthesizer is a combination of circuit functions which generates, or synthesize, many output signals from only a few input signals. Preferably, only one input signal is required and typically, a single output signal out of several hundreds or thousand possibilities is generated at a time.

A phase-locked loop (PLL) offers an ideal solution to frequency synthesis. The PLL is essentially a closed loop electronic servomechanism whose output is locked onto, and will track, a reference signal. This is accomplished using three basic elements: a phase detector, a loop filter (low-pass filter), and a voltage controlled oscillator (VOC). A reference signal also is required as a second input to the phase detector.

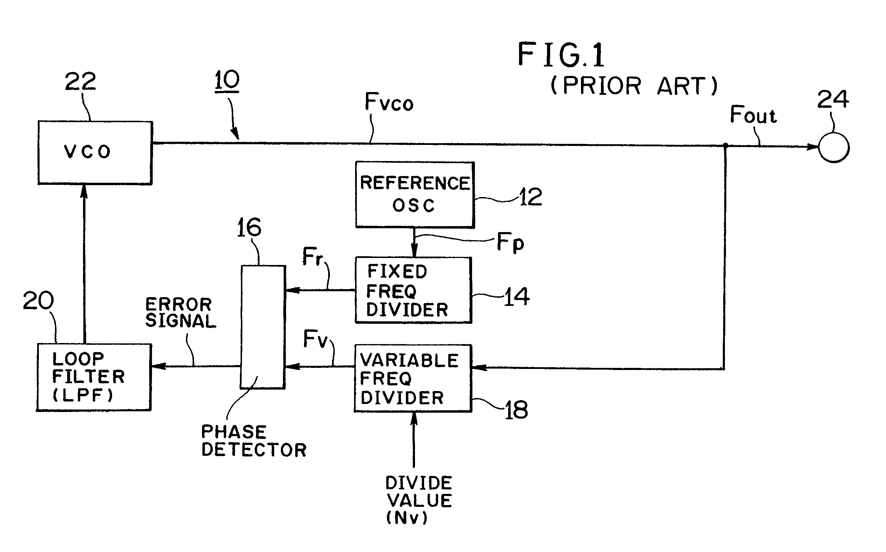

Before describing the present invention, a typical conventional frequency synthesizer using a PLL will be discussed with reference to Fig. 1.

It should be noted that, throughout the instant specification, each signal and corresponding frequency thereof will be denoted by corresponding reference characters for the sake of convenience.

As shown in Fig. 1, a known frequency synthesizer 10 comprises a reference oscillator 12 which generates a signal of suitable frequency accuracy and stability to satisfy system requirements. An output Fp of the reference oscillator 12 is applied to a fixed frequency divider 14. The divider 14 divides the reference oscillator frequency Fp using a given divide value and generates a reference signal Fr. The reference signal Fr is fed to a phase detector 16 which also receives a signal Fv from a variable frequency divider 18. The phase detector 16 compares the phases of the two signals Fr and Fv, and generates an error signal which is proportional to the phase difference between said two signals Fr and Fv. The error signal is filtered by a loop filter (low-pass filter) 20 to smooth and shape it into a voltage suitable for controlling a VCO 22. When the output of the loop filter 20 is applied to the VCO 22, the output frequency Fvco of the VCO 22 is induced to change in a direction to establish a constant phase difference (typically "zero") between the two signals Fr and Fv. The output signal Fvco of the VCO 22 is also the output Fout of the synthesizer 10 and is applied to external circuitry through an output terminal 24. The signal Fvco is split and fed back to the variable frequency divider 18. It is typical to use a programmable counter as the variable frequency divider 18.

Let it be assumed that a divide value of the variable frequency divider 18 is Nv, then the relationship expressed in following equation is obtained in the case of a "locked condition".

$$Fvco\ (Fout) = Fr \cdot Nv \qquad (1)$$

Accordingly, the output frequency Fout is maintained at a frequency equal to (Fr·Nv) in a "locked condition" of the synthesizer 10. The divide value Nv can be changed by programming the counter 18, a host of output signals with different frequencies is possible. Each output signal of the frequency synthesizer 10 appears individually and is separated in frequency from an adjacent frequency by an amount equal to the reference signal frequency Fr. The amount of frequency separation is also referred to as "channel spacing".

It will be understood from equation (1) that, if the channel spacing (viz., Fr) is narrowed while maintaining the output frequency Fout high, the divide value Nv should be increased.

However, if the divide value Nv is increased, the following problems are undesirably invited with the conventional frequency synthesizer shown in Fig. 1.

That is to say, an open loop gain of a PLL type frequency synthesizer is lowered in that the open loop gain is inversely proportional to the divide value Nv. This leads to narrowing of a frequency range within which the synthesizer 10 can be pulled into a "locked condition". Consequently, a loop response of the frequency synthesizer 10 is reduced. In other words, in the case where the output frequency of the synthesizer is high and the channel spacing is narrow, the known frequency synthesizer has encountered the difficulties in that a switching time for changing output frequencies is decreased.

Further, if the reference frequency is lowered to narrow the channel spacing, a cut off frequency of the low pass filter 20 should be reduced for sufficiently attenuating undesired frequency components of Fr, which leaks from the phase detector 16. This also causes a loop response slow down.

## SUMMARY OF THE INVENTION

It is an object of the present invention to provide a frequency synthesizer using a phase-locked loop which features a quick loop response.

Another object of the present invention is to provide a frequency synthesizer using a phase-locked loop which features a high switching time for changing output frequencies.

In brief, the above objects are achieved by an improved a phase-locked loop type frequency synthesizer. The frequency synthesis is accomplished by a closed loop arrangement comprising: a reference oscillator, a phase detector, a programmable counter, a phase detector, a loop filter, a voltage controlled oscillator (VCO), and a frequency translator. The phase detector is supplied with a reference signal from the reference oscillator and a signal from the programmable counter, and compares phases of the two signals. A frequency translator is provided in a manner to receive the signal from the VCO and downward translate the frequency of the signal received. The output of the frequency translator is fed to the programmable counter which divides a signal applied by a variable divide value and applies the divided signal to the phase detector.

More specifically a first aspect of the present invention comes in a frequency synthesizer using a phase-locked loop, comprising: first means, the first means generating a reference signal; second means, the second means receiving a second signal and dividing the frequency of the second signal by a variable divide value and outputting a third signal; third means, the third means coupled to receive the reference signal and the third signal, the third means comparing phases of the reference signal and the third signal and generating an error signal; fourth means, the fourth means coupled to receive the error signal and generating a fourth signal which is controlled in frequency by the error signal and which is derived as an output of the frequency synthesizer; and fifth means, the fifth means being coupled to receive the fourth signal, the fifth means translating the frequency of the fourth signal downward and applying the downward translated frequency signal to the second means as the second signal.

A second aspect of the present invention comes in a frequency synthesizer using a phase-locked loop, comprising: first means, the first means generating a reference signal; second means, the second means receiving a second signal and dividing the frequency of the second signal by a variable divide value and outputting a third signal; third means, the third means coupled to receive the reference signal and the third signal, the third means comparing phases of the reference signal and the third signal and generating an error signal; fourth means, the fourth means receiving the error signal and generating a fourth signal whose frequency is controlled by the error signal; and fifth means, the fifth means coupled to receive the fourth signal, the fifth means dividing the frequency of the fourth signal by a predetermined divide value and generating a fifth signal as an output of the frequency synthesizer.

A third aspect of the present invention takes a form of a frequency synthesizer using a phase-locked loop, comprising: first means, the first means generating a reference signal; second means, the second means receiving a second signal and dividing the frequency of the second signal by a variable divide value and outputting a third signal; third means, the third means coupled to receive the reference signal and the third signal, the third means comparing phases of the reference signal and the third signal and generating an error signal; fourth means, the fourth means receiving the error signal and generating a fourth signal whose frequency is controlled by the error signal; fifth means, the fifth means coupled to receive the fourth signal, the fifth means dividing the frequency of the fourth signal by a predetermined divide value and generating a fifth signal; seventh means, the seventh means being coupled to receive the fifth signal, the seventh means translating the frequency of the fifth signal upward and applying the upward translated frequency signal as an output signal of the frequency synthesizer.

## BRIEF DESCRIPTION OF THE DRAWINGS

The features and advantages of the present invention will become more clearly appreciated from the following description taken in conjunction with the accompanying drawings in which like elements are denoted by like reference numerals and in which:

Fig. 1 is a block diagram showing a known frequency synthesizer using a PLL, Fig. 1 having been referred to in the opening paragraphs of the instant specification;

Fig. 2 is a block diagram showing a first embodiment of this invention;

Fig. 3 is a block diagram showing a second embodiment of this invention; and

Fig. 4 is a block diagram showing a variant of the second embodiment of this invention.

## DETAILED DESCRIPTION OF THE PREFERRED EMBODIMENTS

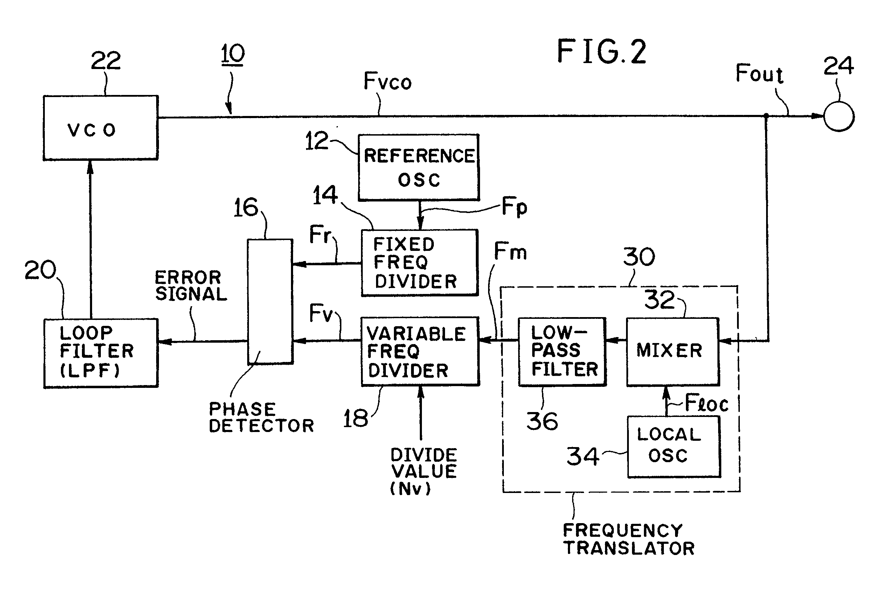

A first preferred embodiment of this invention will be described with reference to Fig. 2.

The first embodiment features a provision of a frequency translator 30 in the feedback loop of the frequency synthesizer 10. The remaining portions of the Fig. 2 arrangement are exactly the same as those of the Fig. 1 arrangement, and hence the descriptions thereof will be omitted for the sake of brevity.

The frequency translator 30 translates the output frequency Fout downward. This downward frequency translation is accomplished by multiplication of the output signal Fvco (= Fout) by a locally generated signal, and subsequent filtering. More specifically, the frequency translator 30 includes a mixer 32 which is supplied with the synthesizer output Fvco and down mixes the same (viz., translates the incoming frequency downward) using a local frequency Floc generated by a local oscillator 34. The output of the mixer 32 is then filtered by a low pass filter 36 for attenuating high frequency components included in the incoming signal. An output Fm of the low pass filter 36 is applied to the variable frequency divider 18.

From equation (1), it can be seen that the relationship expressed in the following equation (2) is obtained when the synthesizer is in a "locked" condition.

$$Nv = Fm/Fr \quad (2)$$

Accordingly, if the frequency Fm is set to a relatively low frequency, then the channel spacing can be narrowed (Fr can be reduced) while maintaining the divide value Nv at a low level. In other words, even if the channel spacing is narrowed, there is no need to increase Nv. Thus, a loop gain is not lowered and can even be raised. Accordingly, high speed switching of the output frequencies Fout is rendered possible. The output frequency Fout of the synthesizer 10 is represented by the following equation (3) when the synthesizer is in a "locked condition".

$$Fvco (Fout) = Fr \cdot Nv + Floc = Fm + Floc \quad (3)$$

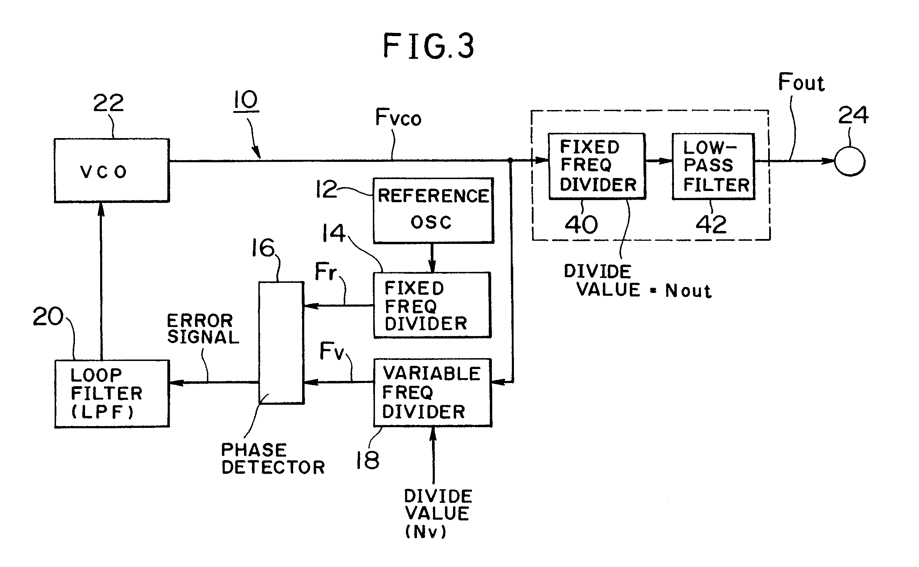

Reference is now made to Fig. 3 wherein a second embodiment of this invention is illustrated in block diagram form.

The arrangement of Fig. 3 includes a fixed frequency divider 40 and a low pass filter 42. The remaining portions of the Fig. 3 arrangement are exactly the same as those of the Fig. 1 arrangement, and hence the descriptions thereof will be omitted for simplicity.

Let it be assumed that: (a) the divide values of the frequency dividers 18, 40 are respectively Nv and Nout; and (b) the output frequencies of the VCO and the synthesizer 10 are respectively Fvco and Fout. Then, we obtain the following relationship when the synthesizer is in a "locked" condition.

$$Fout = Fvco/Nout \quad (4)$$

Since Fvco = Fr·Nv, we have

$$Fout = (Fr/Nout) \cdot Nv \quad (5)$$

It is understood that the synthesizer output Fout is maintained at a frequency equal to (Fr/Nout)·Nv.

This means that the channel spacing is Fr/Nout. In other words, the original channel spacing Fr (Fig. 1) can be reduced by 1/Nout. By way of example, if the synthesizer output Fout is 40 MHz ± 5 KHz, a channel spacing is 50 Hz, and the divide value Nout is 20, then the output frequency of the VCO 22 becomes 800 MHz ± 100 KHz from equation (4).

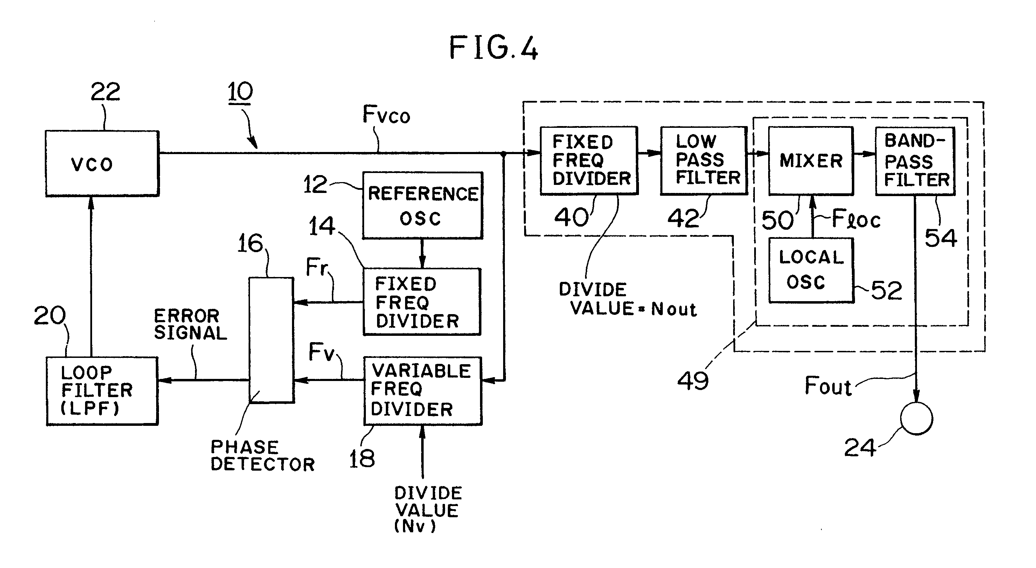

Fig. 4 shows a variant of the second embodiment in block diagram form. The arrangement of Fig. 4 differs from that of Fig. 3 in that the former arrangement further includes a frequency translator 49 which comprises: a mixer 50, a local oscillator 52 and a band pass filter 54.

As mentioned in connection with the second embodiment, Fout = Fvco/Nout (equation (4)). Accordingly, if Nout is set at a relatively high value while maintaining the synthesizer output frequency Fout high, then the output Fvco of the VCO 22 become very high with the result that the VCO 22 is practically very difficult to be manufactured and hence the entire circuitry of Fig. 3 becomes difficult to actually implement. It follows that if a high frequency synthesizer output Fout is necessary, the divide value Nout of the divider 40 can not be set to a large value from a practical point of view. Consequently, a quick loop response is unable to be attained. This modification is directed to solving this difficulty.

Returning to Fig. 4, the frequency translator 49 translates the output frequency of the low-pass filter 42 upward. This upward frequency translation is accomplished by multiplication of the output signal of the filter 42 by a locally generated signal Floc, and subsequent band-pass filtering. More specifically, the mixer 50 is supplied with the output of the low-pass filter 42 and up mixes the same (viz., translates the incoming frequency upward) using the local frequency Floc generated by the oscillator 52. The output of the mixer 50 is applied to the output terminal 24 after being band-pass filtered.

When the synthesizer shown in the drawing remains in a "locked" condition, the relationship expressed in the following equation (6) is established.

$$Fout = (Fvco/Nout) + Floc \quad (6)$$
$$Fr = Fvco/Nv \quad (7)$$

From equations (5) and (6), we have

$$Fout = (Fr/Nout) \cdot Nv + Floc \quad (8)$$

From equation (6), we have

$$Fvco = (Fout - Floc) \cdot Nout \quad (9)$$

wherein (a) Fout and Fvco are respectively the output frequencies of the synthesizer 10 and the VCO, (b) Fr and Floc are respectively the frequencies of the reference signal and the local oscillator 52, and (c) Nv and Nout respectively the divide values of the dividers 18 and 40.

It is understood that (a) the output frequency of the synthesizer 10 is held at {(Fr/Nout)· Nv + Floc} and (b) the channel spacing Fr/Nout. Further, equation (9) indicates that if the difference between Fout and Floc is small, the frequency Fvco does not becomes so high irrespective of high value of Nout. Therefore, if the local frequency Floc is set to a frequency in the vicinity of desired synthesizer output frequencies, then the output frequency of the VCO 22 can be determined within a practically desired range. By way of example, it is assumed that: (a) the synthesizer output Fout is 90 MHz ± 5 KHz; (b) a channel spacing is 50 Hz; (c) the local frequency Floc is 89 MHz; and (d) the divide value Nout is 1000, then the output frequency Fvoc of the VCO 22 becomes 1 GHz ± 5 MHz from equation (7).

While the foregoing description describes two embodiments and one variant thereof according to the present invention, the various alternatives and modifications possible without departing from the scope of the present invention, which is limited only by the appended claims, will be apparent to those skilled in the art.

**Claims**

1. A frequency synthesizer using a phase-locked loop, comprising:
first means, said first means generating a reference signal;
second means, said second means receiving a second signal and dividing the frequency of said second signal by a variable divide value and outputting a third signal;
third means, said third means coupled to receive said reference signal and said third signal, said third means comparing phases of said reference signal and said third signal and generating an error signal;
fourth means, said fourth means coupled to receive said error signal and generating a fourth signal which is controlled in frequency by said error signal and which is derived as an output of said frequency synthesizer; and
fifth means, said fifth means being coupled to receive said fourth signal, said fifth means translating the frequency of said fourth signal downward and applying the downward translated frequency signal to said second means as said second signal.

2. A frequency synthesizer as claimed in claim 1, wherein said fifth means includes:
a mixer coupled to receive said fourth signal;
a local oscillator coupled to said mixer and applying a local frequency thereto; and
a low pass filter interposed between said mixer and said second means.

3. A frequency synthesizer as claimed in claim 1 or 2, wherein said second means is a programmable counter.

4. A frequency synthesizer using a phase-locked loop, comprising:
first means, said first means generating a reference signal;
second means, said second means receiving a second signal and dividing the frequency of said second signal by a variable divide value and outputting a third signal;
third means, said third means coupled to receive said reference signal and said third signal, said third means comparing phases of said reference signal and said third signal and generating an error signal;
fourth means, said fourth means receiving said error signal and generating a fourth signal whose frequency is controlled by said error signal; and
fifth means, said fifth means coupled to receive said fourth signal, said fifth means dividing the frequency of said fourth signal by a predetermined divide value and generating a fifth signal as an output of said frequency synthesizer.

5. A frequency synthesizer as claimed in claim 4, wherein said fifth means includes:
a fixed frequency divider coupled to receive said fourth signal and generating a divided frequency signal; and
a low-pass filter coupled to receive said divided frequency signal from said fixed frequency divider and outputting said fifth signal.

6. A frequency synthesizer as claimed in claim 4 or 5 further including seventh means, said seventh means being coupled to receive said fifth signal, said seventh means translating the frequency of said fifth signal upward and applying the upward translated frequency signal as an output signal of said frequency synthesizer.

7. A frequency synthesizer as claimed in claim 6, wherein said seventh means includes:
a mixer coupled to receive said fifth signal;
a local oscillator coupled to said mixer and applying a local frequency; and
a band-pass filter coupled to said mixer, said band-pass filter generating the output thereof as the output of said frequency synthesizer.

8. A frequency synthesizer using a phase-locked loop, comprising:
first means, said first means generating a reference signal;
second means, said second means receiving a second signal and dividing the frequency of said second signal by a variable divide value and outputting a third signal;
third means, said third means coupled to receive said reference signal and said third signal, said third means comparing phases of said reference signal and said third signal and generating an error signal;

fourth means, said fourth means receiving said error signal and generating a fourth signal whose frequency is controlled by said error signal;

fifth means, said fifth means coupled to receive said fourth signal, said fifth means dividing the frequency of said fourth signal by a predetermined divide value and generating a fifth signal;

seventh means, said seventh means being coupled to receive said fifth signal, said seventh means translating the frequency of said fifth signal upward and applying the upward translated frequency signal as an output signal of said frequency synthesizer.

9. A frequency synthesizer as claimed in claim 8, wherein said fifth means includes:

a fixed frequency divider coupled to receive said fourth signal and generating a divided frequency signal; and

a low-pass filter coupled to receive said divided frequency signal from said fixed frequency divider and outputting said fifth signal.

10. A frequency synthesizer as claimed in claim 8 or 9, wherein said seventh means includes:

a mixer coupled to receive said fifth signal;

a local oscillator coupled to said mixer and applying a local frequency; and

a band-pass filter coupled to said mixer, said band-pass filter generating the output thereof as the output of said frequency synthesizer.

# FIG.1
## (PRIOR ART)

EP 0 409 127 A2

## FIG.2

EP 0 409 127 A2

# FIG.3

EP 0 409 127 A2

# FIG.4

EP 0 409 127 A2